# EUROPÄISCHE PATENTSCHRIFT

(11) **EP 4 420 184 B1**
(45) Veröffentlichungstag und Bekanntmachung des Hinweises auf die Patenterteilung: **16.04.2025**
(21) Anmeldenummer: 23757846.3
(22) Anmeldetag: 08.08.2023
(51) Int. Cl.: G01R 31/52, G01R 31/54, H01M 10/48, G01R 31/36

(54) **VERFAHREN ZUM BESTIMMEN EINES THERMISCHEN DURCHGEHENS EINES ELEKTRISCHEN ENERGIESPEICHERS EINES ZUMINDEST TEILWEISE ELEKTRISCH BETRIEBENEN KRAFTFAHRZEUGS, COMPUTERPROGRAMMPRODUKT SOWIE ELEKTRONISCHE RECHENEINRICHTUNG**
METHOD FOR DETERMINING THERMAL RUNAWAY OF AN ELECTRICAL ENERGY STORAGE UNIT OF AN AT LEAST PARTIALLY ELECTRICALLY OPERATED MOTOR VEHICLE, COMPUTER PROGRAM PRODUCT AND ELECTRONIC COMPUTING DEVICE
PROCÉDÉ DE DÉTERMINATION D'EMBALLEMENT THERMIQUE D'UNE UNITÉ DE STOCKAGE D'ÉNERGIE ÉLECTRIQUE D'UN VÉHICULE AUTOMOBILE AU MOINS PARTIELLEMENT ÉLECTRIQUE, PRODUIT PROGRAMME D'ORDINATEUR ET DISPOSITIF INFORMATIQUE ÉLECTRONIQUE

(30) Priorität: 29.08.2022 DE 102022003147
(43) Veröffentlichungstag der Anmeldung: 28.08.2024
(73) Patentinhaber: Mercedes-Benz Group AG, 70372 Stuttgart (DE)
(72) Erfinder: SCHMIDT, Jan Philipp, 95473 Creußen (DE); KOMHARD, Philipp, 71032 Böblingen (DE)
(74) Vertreter: Novagraaf Group
(86) Internationale Anmeldenummer: PCT/EP2023/071955
(87) Internationale Veröffentlichungsnummer: WO 2024/046721

(56) Entgegenhaltungen:
- EP-A1- 3 843 195
- WO-A1-2015/139927
- KR-A- 20220 040 190

## Beschreibung

Die Erfindung betrifft ein Verfahren zum Bestimmen eines thermischen Durchgehens eines elektrischen Energiespeichers eines zumindest teilweise elektrisch betriebenen Kraftfahrzeugs mittels einer elektronischen Recheneinrichtung des Kraftfahrzeugs gemäß dem Oberbegriff von Patentanspruch 1. Ferner betrifft die Erfindung ein Computerprogrammprodukt, sowie eine elektronische Recheneinrichtung.

Es ist bereits bekannt, dass wenn es beispielsweise in einer so genannten Traktionsbatterie als elektrischer Energiespeicher eines Kraftfahrzeugs zu einem thermischen Durchgehen, was auch als Thermal Runaway bezeichnet wird, kommen kann, müssen Insassen des Kraftfahrzeugs fünf Minuten, bevor beispielsweise ein Feuer ausbricht, gewarnt werden. Aktuell wird hierbei im Fahrzeug eine Kombination von Spannungsmessung und Isolationsmessung eingesetzt. Wird sowohl eine Unterspannung als auch ein Isolationsfehler detektiert, wird ein Alarm ausgelöst. Allerdings ist die Messung des Isolationsfehlers relativ fehleranfällig. Ferner ist auch die Integration eines dezidierten zusätzlichen Sensors, wie zum Beispiel eines Drucksensors bekannt. Dies führt jedoch zu höheren Kosten. Weiterhin kann die Zelltemperatur selbst herangezogen werden. Da jedoch nicht jede Batteriezelle über einen Sensor verfügt und zudem abhängig vom Einbauort auch gut von den heißen Gasen abgeschirmt sein kann, kann bei Temperatursensoren auch ein recht hoher Zeitversatz auftreten. Eine alleinige Messung der Zellspannung ist unzuverlässig, da es in diesem Fall zu häufigen Fehlbewarnungen kommen kann. Reißt zum Beispiel eine Messleitung ab, würde dies ohne ein weiteres Signal zur Plausibilisierung zu einer Fehlbewarnung aufgrund einer scheinbaren Unterspannung führen.

Die EP 3 843 195 A1 bezieht sich auf eine Vorrichtung zur Erkennung des thermischen Durchgehens, ein Batteriesystem und ein Verfahren zur Erkennung des thermischen Durchgehens des Batteriesystems, wobei die Vorrichtung zur Erkennung des thermischen Durchgehens folgendes umfasst: Ein erstes Messmodul zum Messen von Temperaturwerten der mehreren Zellen über mindestens einen Temperatursensor; ein zweites Messmodul zum Messen eines Ausgangsspannungswerts des Batteriesystems; und einen Controller zum Bestimmen der Gültigkeit der Erkennung eines thermischen Durchgehens auf der Grundlage des Temperaturwerts durch Überwachung von Daten, die von dem ersten Messmodul empfangen werden, und zum Erkennen eines thermischen Durchgehens des Batteriesystems durch selektives Überwachen des Temperaturwerts oder des Ausgangsspannungswerts gemäß einem Ergebnis der Gültigkeitsbestimmung der Erkennung eines thermischen Durchgehens auf der Grundlage des Temperaturwerts.

Aufgabe der vorliegenden Erfindung ist es, ein Verfahren, ein Computerprogrammprodukt sowie eine elektronische Recheneinrichtung zu schaffen, mittels welcher verbessert ein thermisches Durchgehen eines elektrischen Energiespeichers detektiert werden kann.

Diese Aufgabe wird durch ein Verfahren, ein Computerprogrammprodukt sowie durch eine elektronische Recheneinrichtung gemäß den unabhängigen Patentansprüchen gelöst. Vorteilhafte Ausgestaltungsformen sind in den Unteransprüchen angegeben.

Ein Aspekt der Erfindung betrifft ein Verfahren zum Bestimmen eines thermischen Durchgehens eines elektrischen Energiespeichers eines zumindest teilweise elektrisch betriebenen Kraftfahrzeugs mittels einer elektronischen Recheneinrichtung des Kraftfahrzeugs. Es erfolgt ein dauerhaftes Überwachen des elektrischen Energiespeichers mittels zumindest eines Diagnoseverfahrens zum Bestimmen eines aktuellen Zustands des elektrischen Energiespeichers auf Basis eines Diagnosesignals. Bei einem Erfassen einer Anomalie im Diagnosesignal erfolgt das Bestimmen einer Häufigkeit der Anomalie im Diagnosesignal über einen vorgegebenen Zeitraum. Ferner erfolgt bei einem Erfassen einer Anomalie im Diagnosesignal das Bestimmen einer Dynamik der Anomalie im Diagnosesignal über einen vorgegebenen Zeitraum. Es wird eine Kommunikationsleitung des elektrischen Energiespeichers mittels eines limitierten Anomaliezählers dauerhaft überwacht. Bei dem Erfassen einer Anomalie innerhalb der Kommunikationsleitung erfolgt ein Vergleichen des limitierten Anomaliezählers mit einem unlimitierten Anomaliezähler und in Abhängigkeit davon ein Erzeugen eines Differenzsignals. Es erfolgt das Bestimmen des thermischen Durchgehens in Abhängigkeit von der bestimmten Häufigkeit und der bestimmten Dynamik und des Differenzsignals.

Dadurch ist es ermöglicht, dass verbessert ein thermisches Durchgehen innerhalb eines elektrischen Energiespeichers erkannt werden kann.

Insbesondere kann somit ein thermisches Durchgehen einer Batteriezelle beziehungsweise elektrischen Energiespeichers, insbesondere in Form einer Lithium-Ionen-Batterie, ohne zusätzliche Sensorik robust detektiert werden. Da die Zellüberwachungselektronik ohnehin Bestandteil eines elektrischen Energiespeichers, insbesondere einer Traktionsbatterie eines Kraftfahrzeugs, ist, ist eine entsprechende Diagnose für die Erreichung einer so genannten ASIL-Sicherheit implementiert, und es entstehen somit keine Bauteilkosten und die Erweiterung der Software ist ebenfalls gering. Somit kann aufwandsreduziert bereits mit bestehenden Systemen beziehungsweise Verfahren das thermische Durchgehen erkannt werden.

Insbesondere erfolgt somit die Verwendung der Zellspannungsmessung, das Durchführen für die Diagnosen für die Zellspannungsmessung, das Berechnen von abgeleiteten Signalen aus den Diagnosen und die Schwellwertbindung und die Zusammenführung der Diagnosen über entsprechende Und-Operationen, um das thermische Durchgehen bestimmen zu können.

Insbesondere ist somit vorgesehen, dass die Zellüberwachungselektronik die Aufgabe hat, die Zellspannungen und die Zelltemperaturen zu messen. Da diese Werte verwendet werden, um Sicherheitsziele mit einer ASIL-Einstufung zu erfüllen, werden diese mittels Diagnosen für die korrekte Funktion ohnehin überprüft. Diese Diagnosen werden getriggert, wenn ein solcher Fehler/Anomalie vorliegt. Bei einem thermischen Durchgehen, was auch als Thermal Runaway bezeichnet wird, treten viele dieser Fehler auf und auch teilweise gleichzeitig. Die Herausforderung besteht nun darin, das thermische Durchgehen von einem tatsächlich vorliegenden Fehlerfall zu trennen. Erschwerend kommt hinzu, dass bei manchen Hardware-Fehlern, insbesondere bei einem nicht vorkommenden Thermal Runaway, auch mehrere Diagnosen getriggert werden. Um hier eine bessere Unterscheidbarkeit zu erreichen, wird zum einen die Dynamik der Fehler, beziehungsweise der Anomalie, sowie auch die Anzahl der gleichzeitig auftretenden Fehler beziehungsweise Anomalien berücksichtigt.

Weiterhin treten bei dem thermischen Durchgehen auch gehäufte Kommunikationsfehler bei der Übertragung über eine so genannte Daisy-Chain, welche vorliegende der Kommunikationsleitung entspricht und beispielsweise als CAN-Bus ausgebildet sein kann, auf. In der Implementierung mit einem so genannten ASIC von analogen Funktionsbauteilen werden diese Fehler mit einem so genannten PEC (Packet Error Counter) gezählt. Dieser PEC entspricht dem unlimitierten Anomaliezähler. Da jedoch auch unter normalen Umständen, beispielsweise beim Schalten von Schützen, mehrere Pakete verfälscht werden können, wird auch hier eine Untersuchung durchgeführt. Hierzu wird der PEC mit einem so genannten Rate-Limiter, mit anderen Worten dem limitierten Anomaliezähler, in der Dynamik begrenzt und es wird dann die Differenz zum tatsächlichen PEC, welcher dem nicht limitierten Anomaliezähler entspricht, bestimmt. Übersteigt dieses Differenzsignal einen Schwellwert, so deutet dies auf ein thermisches Durchgehen hin.

Somit wird aus der Kombination von der Dynamik der Anomalie, der Anzahl der gleichzeitig auftretenden Anomalien, sowie dem Differenzsignal auf das thermische Durchgehen geschlossen, ohne insbesondere Fehldetektionen zu erhalten.

Gemäß einer vorteilhaften Ausgestaltungsform wird mittels des Diagnoseverfahrens eine Unterbrechung einer Zellspannungsleitung überwacht. Insbesondere handelt es sich bei diesem Diagnoseverfahren um ein bereits im Kraftfahrzeug verbautes Diagnoseverfahren zur Überwachung der Zellspannungsmessleitung. Bei diesem Diagnoseverfahren kann nun überprüft werden, ob eine Anomalie vorliegt und dessen Dynamik sowie dessen Häufigkeit überwacht werden. Bei diesem Verfahren handelt es sich insbesondere um ein so genanntes Open-Wire-Verfahren.

Es hat sich weiterhin als vorteilhaft erwiesen, wenn mittels des Diagnoseverfahrens ein Schaltzustand eines Balancing-Halbleiterelements überwacht wird. Bei dem Balancing-Halbleiterelement handelt es sich insbesondere um ein so genanntes Balancing-FET-Element. Insbesondere kann hierbei überprüft werden, ob beispielsweise dieses Halbleiterelement nicht schaltet oder dauernd eingeschaltet ist. Bei diesem Diagnoseverfahren handelt es sich ebenfalls um ein bereits im Kraftfahrzeug verbautes Diagnoseverfahren zur Überwachung des elektrischen Energiespeichers.

Eine weitere vorteilhafte Ausgestaltungsform sieht vor, dass mittels des Diagnoseverfahrens ein Kurzschluss zwischen benachbarten Pins auf einer Platine der elektronischen Recheneinrichtung überwacht wird. Ebenfalls handelt es sich hierbei um bereits im Kraftfahrzeug verbautes Verfahren zur Überwachung des elektrischen Energiespeichers beziehungsweise der elektronischen Recheneinrichtung. Insbesondere handelt es sich dabei um die Überprüfung, ob ein Kurzschluss zwischen benachbarten GPIOs (General purpose input/output), das heißt, die Pins an dem ASIC, an denen zum Beispiel der Temperatursensor angeschlossen ist, überwacht werden.

Weiterhin kann vorgesehen sein, dass mittels des Diagnoseverfahrens eine Abweichung einer zweiten Referenzspannungsquelle überwacht wird. Hiermit handelt es sich ebenfalls um ein bereits im Kraftfahrzeug verbautes Verfahren zur Überwachung der elektrischen Komponenten, insbesondere der Batteriezellen, wodurch auf einfache Art und Weise das thermische Durchgehen bestimmt werden kann.

Es hat sich weiterhin als vorteilhaft erwiesen, wenn mittels des Diagnoseverfahrens eine Summenspannung über eine Platine der elektronischen Recheneinrichtung überwacht wird. Insbesondere wird somit die Summenspannung über den ASIC überwacht, insbesondere ob dieser ungleich der aufsummierten Einzelspannungen ist. Dieses Verfahren ist ebenfalls bereits im Kraftfahrzeug beziehungsweise im elektrischen Energiespeicher verbaut, so dass zuverlässig und auf einfache Art und Weise auf ein thermisches Durchgehen geschlossen werden kann.

Eine weitere vorteilhafte Ausgestaltungsform sieht vor, dass erst bei Überschreiten eines vorgegebenen Schwellwerts zwischen dem limitierten Anomaliezähler und dem unlimitierten Anomaliezähler das Differenzsignal erzeugt wird. Beispielsweise kann eine Ratenlimitierung beim limitierten Anomaliezähler auf vier Fehler pro Sekunde durchgeführt werden. Sollte dann der Schwellwert beispielsweise oberhalb von 20 liegen, so kann dies als Indiz dafür genommen werden, dass ein Fehler/Anomalie vorliegt.

Gemäß einer vorteilhaften Ausgestaltungsform wird bei einem Bestimmen eines potentiellen thermischen Durchgehens eine Warnmeldung für einen Insassen im Kraftfahrzeug auf einer Ausgabeeinrichtung des Kraftfahrzeugs ausgegeben. Insbesondere wird diese Warnmeldung mindestens fünf Minuten vor dem thermischen Durchgehen ausgegeben. Bei der Ausgabeeinrichtung kann es sich sowohl um eine haptische Ausgabeeinrichtung, eine optische Ausgabeeinrichtung oder eine akustische Ausgabeeinrichtung handeln. Insbesondere können auch unterschiedliche Warnmeldungen, beispielsweise ein akustisches Warnsignal, ein optisches Warnsignal sowie ein haptisches Warnsignal gleichzeitig ausgegeben werden.

Bei dem vorgestellten Verfahren handelt es sich um ein computerimplementiertes Verfahren. Daher betrifft ein weiterer Aspekt der Erfindung ein Computerprogrammprodukt mit Programmcodemitteln, welche eine elektronische Recheneinrichtung dazu veranlassen, wenn die Programmcodemittel von der elektronischen Recheneinrichtung abgearbeitet werden, ein Verfahren nach dem vorhergehenden Aspekt durchzuführen. Insbesondere wird das Verfahren mittels der elektronischen Recheneinrichtung durchgeführt. Das Computerprogrammprodukt kann auch als Computerprogramm bezeichnet werden.

Ein weiterer Aspekt der Erfindung betrifft daher auch ein computerlesbares Speichermedium mit dem Computerprogrammprodukt.

Ferner betrifft die Erfindung auch eine elektronische Recheneinrichtung zum Bestimmen eines thermischen Durchgehens eines elektrischen Energiespeichers eines zumindest teilweise elektrisch betriebenen Kraftfahrzeugs, wobei die elektronische Recheneinrichtung zum Durchführen eines Verfahrens nach dem vorhergehenden Aspekt ausgebildet ist. Insbesondere wird das Verfahren mittels der elektronischen Recheneinrichtung durchgeführt.

Die elektronische Recheneinrichtung weist beispielsweise Prozessoren, Schaltkreise, insbesondere integrierte Schaltkreise, sowie weitere elektronische Bauteile auf, um entsprechende Verfahrensschritte durchführen zu können.

Ebenfalls betrifft die Erfindung auch ein zumindest teilweise elektrisch betriebenes beziehungsweise auch ein vollelektrisch betriebenes Kraftfahrzeug.

Vorteilhafte Ausgestaltungsformen des Verfahrens sind als vorteilhafte Ausgestaltungsformen des Computerprogrammprodukts, der elektronischen Recheneinrichtung sowie des Kraftfahrzeugs anzusehen. Die elektronische Recheneinrichtung sowie das Kraftfahrzeug weisen insbesondere Merkmale auf, um entsprechende Verfahrensschritte durchführen zu können.

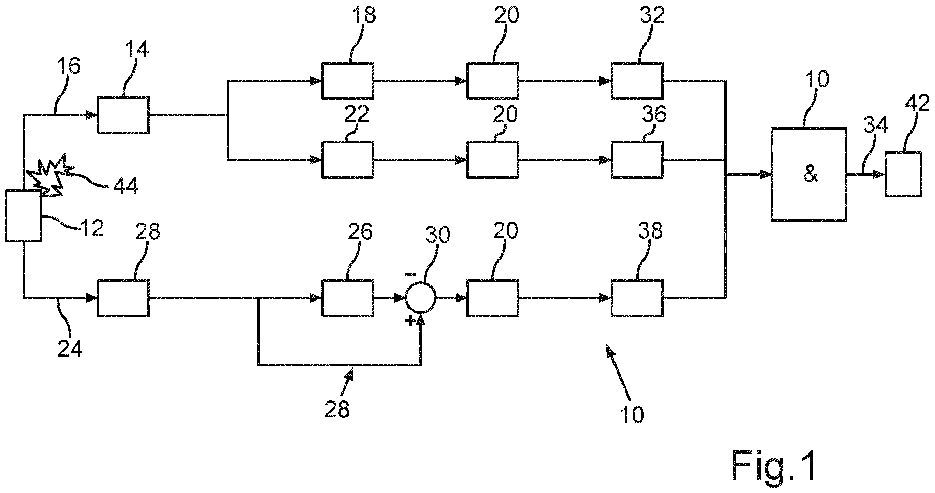

Weitere Vorteile, Merkmale und Einzelheiten der Erfindung ergeben sich aus der nachfolgenden Beschreibung eines bevorzugten Ausführungsbeispiels sowie anhand der Zeichnung. Die vorstehend in der Beschreibung genannten Merkmale und Merkmalskombinationen sowie die nachfolgend in der Figurenbeschreibung genannten und/oder in der einzigen Figur alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

Dabei zeigt die einzige Fig. ein schematisches Blockschaltbild gemäß einer Ausführungsform des Verfahrens.

In der Figur sind gleiche oder funktionsgleiche Elemente mit den gleichen Bezugszeichen versehen.

Die Fig. zeigt ein schematisches Blockschaltbild gemäß einer Ausführungsform einer elektronischen Recheneinrichtung 10 zum Bestimmen eines thermischen Durchgehens eines elektrischen Energiespeichers 12 eines zumindest teilweise elektrisch betriebenen Kraftfahrzeugs. Im vorliegenden Ausführungsbeispiel ist insbesondere ein Ablaufdiagramm gezeigt. Insbesondere erfolgt ein dauerhaftes Überwachen des elektrischen Energiespeichers 12 mittels zumindest eines Diagnoseverfahrens 14 zum Bestimmen eines aktuellen Zustands des elektrischen Energiespeichers 12 auf Basis eines Diagnosesignals 16. Bei einem Erfassen einer Anomalie 44 im Diagnosesignal 16 erfolgt das Bestimmen einer Häufigkeit 18 der Anomalie 44 im Diagnosesignal 16 über einen vorgegebenen Zeitraum 20. Ferner erfolgt beim Erfassen der Anomalie 44 im Diagnosesignal 16 das Bestimmen einer Dynamik 22 der Anomalie 44 im Diagnosesignal 16 über den vorgegebenen Zeitraum 20. Es erfolgt ferner das dauerhafte Überwachen einer Kommunikationsleitung 24 des elektrischen Energiespeichers 12 mittels eines limitierten Anomaliezählers 26. Bei einem Erfassen der Anomalie 44 innerhalb der Kommunikationsleitung 24 erfolgt das Vergleichen des limitierten Anomaliezählers 26 mit einem unlimitierten Anomaliezähler 28 und in Abhängigkeit davon ein Erzeugen eines Differenzsignals 30. Es wird dann wiederum das Bestimmen des thermischen Durchgehens in Abhängigkeit von der bestimmten Häufigkeit 18, der bestimmten Dynamik 22 und des Differenzsignals 30 durchgeführt.

Hierzu kann insbesondere vorgesehen sein, dass ein Schwellwertvergleich durchgeführt wird. Beispielsweise kann beim Maß für die Häufigkeit 18 ein erster Schwellwert 32 von größer 100 vorgesehen sein. Mit anderen Worten, erst wenn mehr oder gleich als 100 Anomalien 44 erkannt werden, kann dies zu einem Warnsignal 34 für das thermische Durchgehen führen. Ferner kann ein zweiter Schwellwert 36 vorgesehen sein, welcher wiederum die Dynamik beschreibt. Beispielsweise kann die Dynamik ein Betrag der Ableitung der Anzahl an gesetzten Bits betreffen und beispielsweise einen zweiten Schwellwert 36 von ≥ 10 umfassen. Es kann ein dritter Schwellwert 38 vorgesehen sein, welcher wiederum das Maß für die auffällig häufig auftretenden Kommunikationsfehler beschreibt, wobei dieses beispielsweise als > 20 angesehen werden kann. Erst wenn die Schwellwertvergleiche alle drei als positiv eingestuft wurden, also die Schwellwerte 32, 36, überschritten wurden, werden diese in einer Und-Operation 40 zusammengefasst. Wenn alle drei Schwellwerte 32, 36, 38 überschritten sind, so erfolgt das Erzeugen einer Warnmeldung 34. Die Warnmeldung 34 kann beispielsweise an einer Ausgabeeinrichtung 42 des Kraftfahrzeugs ausgegeben werden. Beispielsweise kann die Ausgabeeinrichtung 42 als Anzeigeeinrichtung, Lautsprechereinrichtung oder haptische Einrichtung ausgebildet sein.

Der Zeitraum 20 kann beispielsweise 20 Sekunden oder auch eine andere Zeitspanne, beispielsweise 40 Sekunden, betreffen.

Wie bereits erwähnt, ist vorliegend gezeigt, dass eine Und-Operation 40 vorgesehen ist. Eine alternative Umsetzung ist beispielsweise, dass anstelle einer Schwellwertbildung vor der Und-Operation 40 eine Addition mit Gewichtung und dann erst die Schwellwertbildung durchgeführt wird.

Insbesondere zeigt somit die Fig., dass die Zellüberwachungselektronik die Aufgabe hat, die Zellspannung und die Zelltemperatur zu messen. Da diese Werte verwendet werden, um Sicherheitsziele mit einer entsprechenden ASIL-Einstufung zu erfüllen, wird mittels der Diagnoseverfahren 14 die korrekte Funktion überprüft. Solche Diagnosen umfassen zum Beispiel die Unterbrechung der Zellspannungsmessleitung, eine so genannte Open Wire-Diagnose. Ferner können auch Diagnoseverfahren 14 genutzt werden, welche beispielsweise ein Balancing-Halbleiterschaltelement überwacht. Beispielsweise kann überprüft werden, ob dieses Halbleiterelement nicht schaltet oder dauerhaft eingeschaltet ist. Dies kann auch als Balancing-FET-Stuck bezeichnet werden. Des Weiteren kann auch der Kurzschluss zwischen benachbarten Platinen, so genannten General Purpose Input/Output überprüft werden. Hierbei wird insbesondere überprüft, ob die entsprechenden Pins am ASIC, an denen zum Beispiel der Temperatursensor angeschlossen ist, einen Kurzschluss aufweisen. Ferner kann auch eine Abweichung einer zweiten Referenzspannungsquelle als Überwachung genutzt werden. Des Weiteren kann auch die Summenspannung über die ASIC überprüft werden, beispielsweise ob diese ungleich der aufsummierten Einzelspannungen ist.

Diese Diagnoseverfahren 14 werden getriggert, wenn ein solcher Fehler/Anomalie 44 vorliegt. Bei einem thermischen Durchgehen treten viele dieser Fehler auf und auch teilweise gleichzeitig. Die Herausforderung besteht nun darin, das thermische Durchgehen von einem tatsächlich vorliegenden Fehlerfall zu trennen. Erschwerend kommt hinzu, dass bei manchen Hardware-Fehlern, welche nicht einem thermischen Durchgehen entsprechen, auch mehrere Diagnoseverfahren 14 getriggert werden. Um hier die bessere Unterscheidbarkeit zu erreichen, wird zum einen die Dynamik 22 sowie auch die Häufigkeit 18 der Anomalie 44 berücksichtigt.

Weiterhin treten beim thermischen Durchgehen auch gehäufte Kommunikationsfehler bei der Übertragung über die Kommunikationsleitung 24, insbesondere der so genannten Daisy-Chain, auf. In der Implementierung mit dem ASIC von analogen Einrichtungen werden diese Fehler mit einem so genannten unlimitierten Anomaliezähler 28 (Packet Error Counter - PEC) gezählt. Da jedoch auch unter normalen Umständen, zum Beispiel beim Schalten von Schützen, mehrere Pakete verfälscht werden können, wird auch hier eine Unterscheidung durchgeführt. Hierzu wird der PEC mit einem limitierten Anomaliezähler 26, einem so genannte Rate-Limiter, in der Dynamik begrenzt, und dann die Differenz zum tatsächlichen PEC bestimmt. Übersteigt dieses Differenzsignal 30 einen Schwellwert, insbesondere vorliegend den dritten Schwellwert 38, deutet dies auf ein thermisches Durchgehen hin.

Der limitierte Anomaliezähler 26 kann beispielsweise eine Ratenlimitierung auf vier Fehler beziehungsweise Anomalien 44 pro Sekunde durchführen.

Sollte nun sowohl die Häufigkeit 18, die Dynamik 22 als auch das Differenzsignal 30 den entsprechenden Schwellwert 32, 36, 38 überschreiten, so wird auf Basis der Und-Operation 40 das thermische Durchgehen erkannt und das Warnsignal 34 erzeugt.

### Bezugszeichenliste

- 10: elektronische Recheneinrichtung
- 12: elektrischer Energiespeicher
- 14: Diagnoseverfahren
- 16: Diagnosesignal
- 18: Häufigkeit
- 20: Zeitraum
- 22: Dynamik
- 24: Kommunikationsleitung
- 26: limitierter Anomaliezähler
- 28: unlimitierter Anomaliezähler
- 30: Differenzsignal
- 32: erster Schwellwert
- 34: Warnmeldung
- 36: zweiter Schwellwert
- 38: dritter Schwellwert
- 40: Und-Operation
- 42: Ausgabeeinrichtung
- 44: Anomalie

## Patentansprüche

1. Verfahren zum Bestimmen eines thermischen Durchgehens eines elektrischen Energiespeichers (12) eines zumindest teilweise elektrisch betriebenen Kraftfahrzeugs mittels einer elektronischen Recheneinrichtung (10) des Kraftfahrzeugs, mit den Schritten:
- Dauerhaftes Überwachen des elektrischen Energiespeichers (12) mittels zumindest eines Diagnoseverfahrens (14) zum Bestimmen eines aktuellen Zustands des elektrischen Energiespeichers (12) auf Basis eines Diagnosesignals (16);
- Bei einem Erfassen einer Anomalie (44) im Diagnosesignal (16) Bestimmen einer Häufigkeit (18) der Anomalie (44) im Diagnosesignal (16) über einen vorgegebenen Zeitraum (20);
- Bei einem Erfassen einer Anomalie (44) im Diagnosesignal (16) Bestimmen einer Dynamik (22) der Anomalie (44) im Diagnosesignal (16) über einen vorgegebenen Zeitraum (20);
- Dauerhaftes Überwachen einer Kommunikationsleitung (24) des elektrischen Energiespeichers (12) mittels eines limitierten Anomaliezählers (26);
- Bei einem Erfassen einer Anomalie (44) innerhalb der Kommunikationsleitung (24) Vergleichen des limitierten Anomaliezählers (26) mit einem unlimitierten Anomaliezähler (28) und in Abhängigkeit davon Erzeugen eines Differenzsignals (30); und
- Bestimmen des thermischen Durchgehens (44) in Abhängigkeit von der bestimmten Häufigkeit (18) und der bestimmten Dynamik (22) und dem Differenzsignal (30).

2. Verfahren nach Anspruch 1,
**dadurch gekennzeichnet, dass**
mittels des Diagnoseverfahrens (14) eine Unterbrechung einer Zellspannungsmessleitung überwacht wird.

3. Verfahren nach Anspruch 1 oder 2,
**dadurch gekennzeichnet, dass**
mittels des Diagnoseverfahrens (14) ein Schaltzustand eines Balancing-Halbleiterelements überwacht wird.

4. Verfahren nach einem der vorhergehenden Ansprüche,
**dadurch gekennzeichnet, dass**
mittels des Diagnoseverfahrens (14) ein Kurzschluss zwischen benachbarten Pins auf einer Platine der elektronischen Recheneinrichtung (10) überwacht wird.

5. Verfahren nach einem der vorhergehenden Ansprüche,
**dadurch gekennzeichnet, dass**
mittels des Diagnoseverfahrens (14) eine Abweichung einer zweiten Referenzspannungsquelle überwacht wird.

6. Verfahren nach einem der vorhergehenden Ansprüche,
**dadurch gekennzeichnet, dass**
mittels des Diagnoseverfahrens (14) eine Summenspannung über eine Platine der elektronischen Recheneinrichtung (10) überwacht wird.

7. Verfahren nach einem der vorhergehenden Ansprüche,
**dadurch gekennzeichnet, dass**
erst bei einem Überschreiten eines vorgegebenen Schwellwerts zwischen dem limitierten Anomaliezähler (26) und dem unlimitierten Anomaliezähler (38) das Differenzsignal (30) erzeugt wird.

8. Verfahren nach einem der vorhergehenden Ansprüche,
**dadurch gekennzeichnet, dass**
bei einem Bestimmen eines potentiellen thermischen Durchgehens eine Warnmeldung (34) für einen Insassen im Kraftfahrzeug auf einer Ausgabeeinrichtung (42) des Kraftfahrzeugs ausgegeben wird.

9. Computerprogrammprodukt mit Programmcodemitteln, welche eine elektronische Recheneinrichtung (10) dazu veranlassen, wenn die Programmcodemittel von der elektronischen Recheneinrichtung (10) abgearbeitet werden, ein Verfahren nach einem der Ansprüche 1 bis 8 durchzuführen.

10. Elektronische Recheneinrichtung (10) zum Bestimmen eines thermischen Durchgehens eines elektrischen Energiespeichers (12) eines zumindest teilweise elektrisch betriebenen Kraftfahrzeugs, wobei die elektronische Recheneinrichtung (10) zum Durchführen eines Verfahrens nach einem der Ansprüche 1 bis 8 ausgebildet ist.

## Claims

1. Method for determining a thermal runaway of an electrical energy storage device (12) of an at least partially electrically operated motor vehicle by means of an electronic computing device (10) of the motor vehicle, comprising the steps of:
- continuously monitoring the electrical energy storage device (12) by means of at least one diagnostic method (14) for determining a current state of the electrical energy storage device (12) on the basis of a diagnostic signal (16);
- if an anomaly (44) is detected in the diagnostic signal (16), determining a frequency (18) of the anomaly (44) in the diagnostic signal (16) over a predetermined period of time (20);
- if an anomaly (44) is detected in the diagnostic signal (16), determining a dynamic range (22) of the anomaly (44) in the diagnostic signal (16) over a predetermined period of time (20);
- continuously monitoring a communication line (24) of the electrical energy storage device (12) by means of a limited anomaly counter (26);
- if an anomaly (44) is detected within the communication line (24), comparing the limited anomaly counter (26) with an unlimited anomaly counter (28) and generating a difference signal (30) on the basis of the comparison; and
- determining the thermal runaway (44) on the basis of the determined frequency (18) and the determined dynamic range (22) and the difference signal (30).

2. Method according to claim 1,
**characterized in that**
a break in a cell voltage measuring line is monitored by means of the diagnostic method (14).

3. Method according to claim 1 or claim 2,
**characterized in that**
a switching state of a balancing semiconductor element is monitored by means of the diagnostic method (14).

4. Method according to any of the preceding claims,
**characterized in that**
a short circuit between adjacent pins on a circuit board of the electronic computing device (10) is monitored by means of the diagnostic method (14).

5. Method according to any of the preceding claims,
**characterized in that**
a deviation of a second reference voltage source is monitored by means of the diagnostic method (14).

6. Method according to any of the preceding claims,
**characterized in that**
a sum voltage across a circuit board of the electronic computing device (10) is monitored by means of the diagnostic method (14).

7. Method according to any of the preceding claims,
**characterized in that**
the difference signal (30) is only generated when a predetermined threshold value between the limited anomaly counter (26) and the unlimited anomaly counter (38) is exceeded.

8. Method according to any of the preceding claims,
**characterized in that**
upon determining a potential thermal runaway, a warning message (34) for an occupant in the motor vehicle is output on an output device (42) of the motor vehicle.

9. Computer program product comprising program code means which cause an electronic computing device (10) to carry out a method according to any of claims 1 to 8 when the program code means are processed by the electronic computing device (10).

10. Electronic computing device (10) for determining a thermal runaway of an electrical energy storage device (12) of an at least partially electrically operated motor vehicle, wherein the electronic computing device (10) is designed to carry out a method according to any of claims 1 to 8.

## Revendications

1. Procédé permettant de déterminer un emballement thermique d'un accumulateur d'énergie électrique (12) d'un véhicule automobile fonctionnant au moins partiellement de manière électrique, au moyen d'un dispositif de calcul électronique (10) du véhicule automobile, comportant les étapes consistant à :
- surveiller en permanence l'accumulateur d'énergie électrique (12) au moyen d'au moins un procédé de diagnostic (14) permettant de déterminer un état actuel de l'accumulateur d'énergie électrique (12) sur la base d'un signal de diagnostic (16) ;
- lors de la détection d'une anomalie (44) dans le signal de diagnostic (16), déterminer une fréquence (18) de l'anomalie (44) dans le signal de diagnostic (16) sur une période de temps (20) prédéfinie ;
- lors de la détection d'une anomalie (44) dans le signal de diagnostic (16), déterminer une dynamique (22) de l'anomalie (44) dans le signal de diagnostic (16) sur une période de temps (20) prédéfinie ;
- surveiller en permanence une ligne de communication (24) de l'accumulateur d'énergie électrique (12) au moyen d'un compteur d'anomalies limité (26) ;
- lors de la détection d'une anomalie (44) à l'intérieur de la ligne de communication (24), comparer le compteur d'anomalies limité (26) à un compteur d'anomalies non limité (28) et, en fonction de cela, générer un signal différentiel (30) ; et
- déterminer l'emballement thermique (44) en fonction de la fréquence (18) déterminée et de la dynamique (22) déterminée et du signal différentiel (30).

2. Procédé selon la revendication 1,
**caractérisé en ce que**
une interruption d'une ligne de mesure de tension de cellule est surveillée au moyen du procédé de diagnostic (14).

3. Procédé selon la revendication 1 ou 2,
**caractérisé en ce que**
un état de commutation d'un élément semi-conducteur d'équilibrage est surveillé au moyen du procédé de diagnostic (14).

4. Procédé selon l'une des revendications précédentes,
**caractérisé en ce que**
un court-circuit entre des broches voisines sur une carte de circuit imprimé du dispositif de calcul électronique (10) est surveillé au moyen du procédé de diagnostic (14).

5. Procédé selon l'une des revendications précédentes,
**caractérisé en ce que**
une déviation d'une seconde source de tension de référence est surveillée au moyen du procédé de diagnostic (14).

6. Procédé selon l'une des revendications précédentes,
**caractérisé en ce que**
une tension cumulée sur une carte de circuit imprimé du dispositif de calcul électronique (10) est surveillée au moyen du procédé de diagnostic (14).

7. Procédé selon l'une des revendications précédentes,
**caractérisé en ce que**
le signal différentiel (30) est généré uniquement en cas de dépassement d'une valeur seuil prédéfinie entre le compteur d'anomalies limité (26) et le compteur d'anomalies non limité (38).

8. Procédé selon l'une des revendications précédentes,
**caractérisé en ce que**
un message d'avertissement (34) pour un occupant dans le véhicule automobile est émis sur un dispositif de sortie (42) du véhicule automobile lors d'une détermination d'un emballement thermique potentiel.

9. Produit programme informatique comportant des moyens de code de programme qui amènent un dispositif de calcul électronique (10), lorsque les moyens de code de programme sont traités par le dispositif de calcul électronique (10), à exécuter un procédé selon l'une des revendications 1 à 8.

10. Dispositif de calcul électronique (10) permettant de déterminer un emballement thermique d'un accumulateur d'énergie électrique (12) d'un véhicule automobile fonctionnant au moins partiellement de manière électrique, dans lequel le dispositif de calcul électronique (10) est configuré pour exécuter un procédé selon l'une des revendications 1 à 8.
